# EUROPEAN PATENT SPECIFICATION

(11) **EP 0 393 488 B1**
(45) Date of publication and mention of the grant of the patent: **02.08.1995**
(21) Application number: 90106922.9
(22) Date of filing: 11.04.1990
(51) Int. Cl.: H01J 29/07, H01J 9/14, H01J 29/02

(54) **Grid apparatus for use with a color cathode ray tube**
Gitter für eine Farbbildkathodenstrahlröhre
Grille pour un tube à rayons cathodiques en couleurs

(30) Priority: 18.04.1989 JP 97853/89
(43) Date of publication of application: 24.10.1990
(73) Proprietor: SONY CORPORATION, Tokyo (JP)
(72) Inventor: Kume, Hisao, Ohya-cho, Inazawa-shi, Aichi-ken (JP); Kuwajima, Shuichi, Ohya-cho, Inazawa-shi, Aichi-ken (JP); Sanma, Takahide, Ohya-cho, Inazawa-shi, Aichi-ken (JP)
(74) Representative: TER MEER STEINMEISTER & PARTNER GbR

(56) References cited:
- US-A- 4 437 036
- US-A- 4 495 437
- PATENT ABSTRACTS OF JAPAN, vol. 12, no. 168 (E-611)[3015], 20th May 1988 ; & JP-A-62 278 738
- R.C. WEAST et al.: "Chemical Rubber Company Handbook Of Chemistry And Physics", 63rd edition, 1982-1983, CRC Press Inc., Boca Raton, Florida, US.
- PATENT ABSTRACTS OF JAPAN, vol. 12, no. 127 (E-602)[2974], 20th April 1988 ; & JP-A-62 252 031
- PATENT ABSTRACTS OF JAPAN, vol. 6, no. 123 (E-117)[1001], 8th July 1982 ; & JP-A-57 50 739
- PATENT ABSTRACTS OF JAPAN, vol. 10, no. 302 (E-445)[2358], 15th October 1986 ; & JP-A-61 116 734

## Description

### BACKGROUND OF THE INVENTION

### Field of the Invention

The present invention relates to a grid apparatus for a color cathode ray tube which eliminates vibration of the grids and to a method of making such grid apparatus.

### Description of Related Art

In conventional grid apparatus for a color cathode ray tube, aperture grills are known such as disclosed in Japanese Patent Publication Nos. 59 (1984)-18825 and 59 (1984)-18826. In such a grid apparatus, as shown in FIG. 4, a frame 5 comprises a pair of support bars 1, 2 disposed in parallel to each other with a predetermined space therebetween, and resilient support members 3, 4 which are substantially U-shaped are attached between the ends of the support bars 1, 2. A multiplicity of parallel spaced ribbon-shaped grid elements 6 are attached after being stretched with the required tension and at a predetermined pitch between the two support bars 1, 2 as shown. In making the grid apparatus 7, the grid elements 6 are welded to the frame 5 during a condition when they are stretched and deformed by pressure. Then they are welded after which the pressure which placed them in tension is released. Thus, the grid elements 6 are in a stretched condition and then they are heat-treated to blacken them in a temperature range of about 450 to 470°C.

However, thermal creep occurs in the grid apparatus 7 during the blackening process because the high temperature causes the stretched grid elements 6 to be expanded. Also, spring-back of the frame 5 causes the tension to become lower in the grid elements 6 after the heat treatment than the tension was prior to the heat treatment. Although the thermal creep occurs principally during the blackening process in the heat treatment, it also can occur at the time when frit sealing of a panel and a funnel in the heat treatment (at 440°C or so) is done.

Therefore, when a television receiver with a color cathode ray tube is placed in operation after completion of the above processes, the grid elements 6 of the grid apparatus 7 will vibrate which is caused by sound in the television set which generates image noise. One of effective means for reducing such image noise is to maintain a higher tension of the grid elements 6. However, since the tension applied prior to the heat treatment is very close to the breaking strength limit of the grid elements 6, the tension cannot be further increased.

### SUMMARY OF THE INVENTION

It is an object of the present invention to provide an improved grid apparatus which is capable of preventing thermal creep of the grid elements during the heat treatment which occurs in the prior art.

Another object of the present invention is to provide a method of making an improved grid apparatus with additional execution of a heat treatment such as a blackening process.

According to the invention, a grid apparatus for a color cathode ray tube. comprising:
a frame comprising a pair of mutually opposed support bars and a pair of resilient support members attached between said support bars; and
a plurality of parallel ribbon-shaped grid elements stretched under tension and attached to said frame;
is characterized by metallic members which have a larger thermal expansion coefficient than said resilient support members connected to reverse surfaces of said resilient support members on the sides which are opposite to the grid elements. In this structure, during heat treatment the grid elements of the grid apparatus will not be subjected to thermal creep and high tension in the grid elements will be maintained when the normal temperature state is resumed.

A method according to the present invention for making the above grid apparatus includes the following steps:
stretching the grid elements with a predetermined tension on the frame;
attaching metallic members to respective surfaces of the two resilient support members, on the sides which are opposite to the grid elements, said metallic members having a larger coefficient of thermal expansion than said resilient support members; and
carrying out heat treatment whereby the tension which is applied to said grid elements by said resilient support members and said support bars is reduced. Thereby, thermal creep of the grid elements is eliminated so as to allow the manufacture of a highly reliable grid apparatus in which high tension of the grid elements is maintained.

Other objects, features and advantages of the invention will be readily apparent from the following description of certain preferred embodiments thereof taken in conjunction with the accompanying drawings although variations and modifications may be effected without departing from the spirit and scope of the novel concepts of the disclosure, and in which:

### BRIEF DESCRIPTION OF THE DRAWINGS

FIG. 1 is a perspective view of an exemplary grid apparatus embodying the present invention;
FIG. 2 is a side view illustrating the present invention;
FIG. 3 is a graph which shows the relationship between thermal creep rate and thermal expansion rate of a metallic grid member; and
FIG. 4 is a perspective view of a conventional grid apparatus.

### DESCRIPTION OF THE PREFERRED EMBODIMENTS

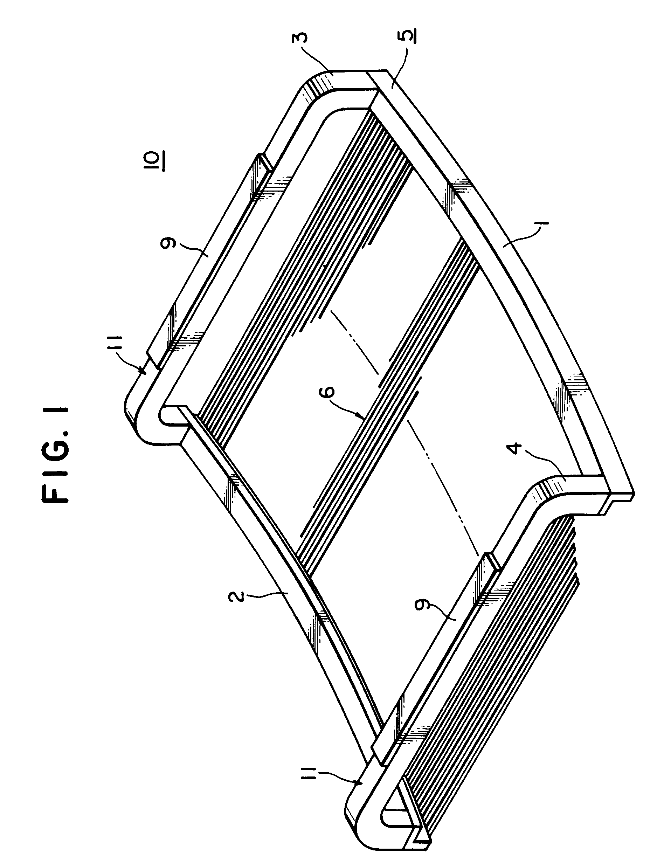

A grid apparatus and a method of making it according to the present invention will be described with reference to FIGS. 1 through 3.

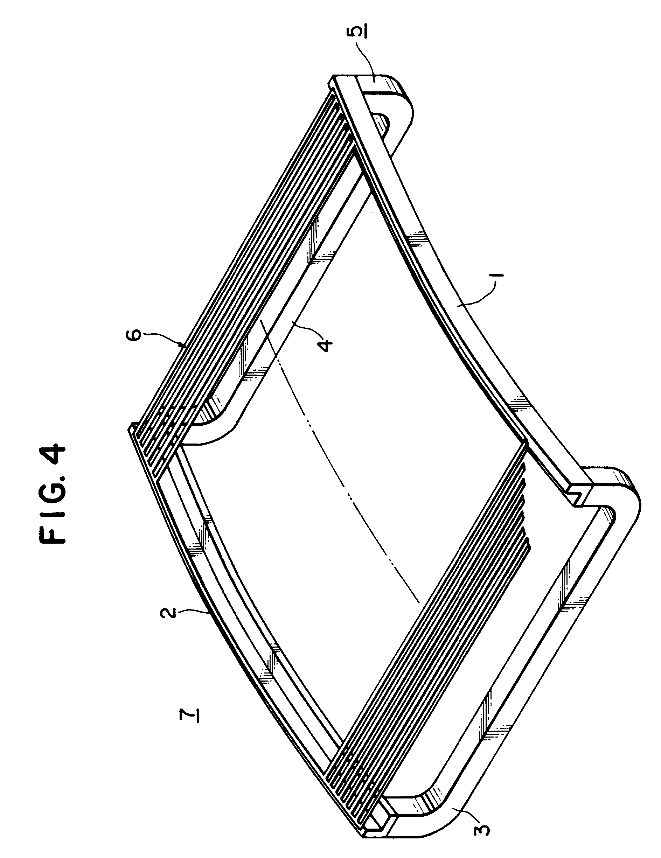

FIG. 1 illustrates an exemplary grid apparatus embodying the present invention, wherein a frame 5 is substantially structurally the same as the conventional example mentioned in connection with FIG. 4. The frame 5 comprises a pair of support bars 1, 2 which are parallel to each other with a predetermined space between them. A pair of resilient U-shaped support members 3, 4 are attached between the ends of the two support bars 1, 2. A multiplicity of ribbon-shaped grid elements 6 are stretched with the required tension and then attached to one surface 5a of the frame 5 with a predetermined pitch between each grid element so as to bridge the space between the support bars 1, 2.

In this embodiment, metallic members 9 which have a larger thermal expansion coefficient than the resilient support members 3, 4 are attached by welding or other suitable means to the reverse surfaces 11 which are opposite to the side where the grid elements 6 are attached of the resilient support members 3, 4 which form the frame 5.

The metallic members 9 which are attached to the resilient support members 3, 4 in this embodiment are composed of stainless steel which has a thermal expansion coefficient of 20 x 10⁻⁶ or so which is greater than the coefficient of 10 x 10⁻⁶ to 12 x 10⁻⁶ of the resilient support members 3, 4. However, it is to be understood that the thermal expansion coefficient of the metallic members 9 is not limited only to the above exemplary value, and a satisfactory results can be achieved if such coefficient is within a range of 15 x 10⁻⁶ to 50 x 10⁻⁶. Furthermore, as described above, the grid elements 6 are stretched with a desired tension on the frame 5 and, after the metallic members 9 are attached to the respective surfaces 11 of the two resilient support members 3, 4, a blackening process is executed at a high temperature 450 to 470°C to produce a desired grid apparatus.

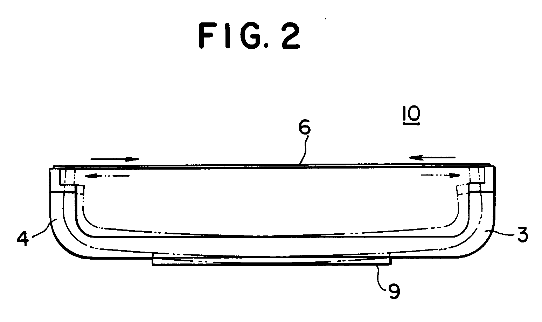

In the grid apparatus 10 of such construction, the resilient support members 3, 4 are deformed so that they have a curvature, principally during the blackening process during heat treatment, and the curvature is in a direction so as to loosen the grid elements 6 and this is shown by a chain line in FIG. 2. This is due to the difference between the thermal expansion coefficients of the resilient support members 3, 4 and the metallic members 9, which causes the tension which is applied to the grid elements 6 to be reduced so as to consequently diminish the thermal creep of the grid elements 6.

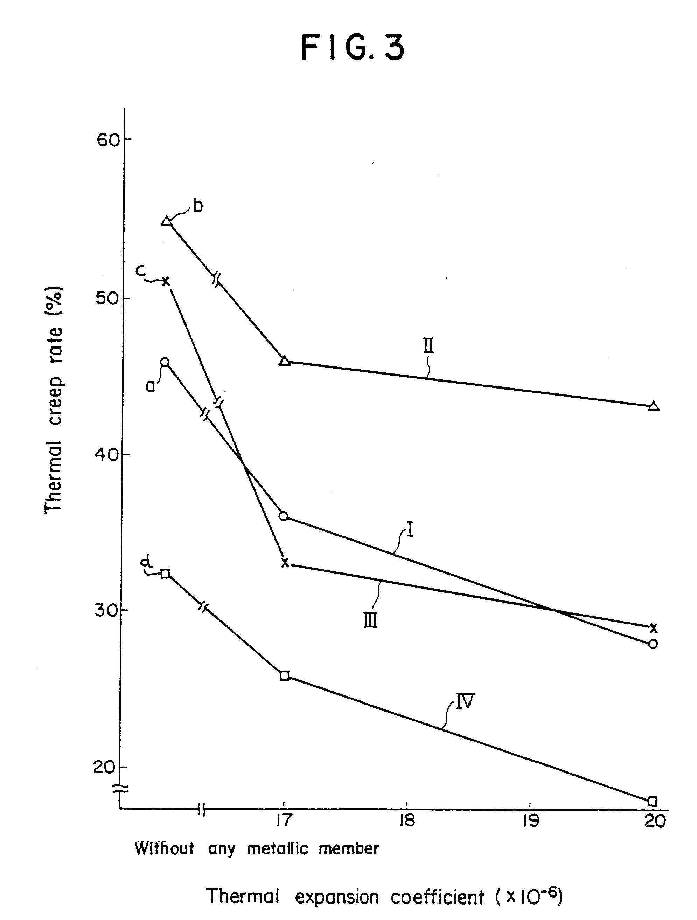

FIG. 3 graphically shows the relationship between the thermal creep rate and the thermal expansion coefficient of the metallic member 9, wherein the thermal creep rate relative to the tension of the grid elements 6 which is reduced by the heat treatment is defined in percent (%). In this graphic representation, curves (I), (II), (III) and (IV) denote the values obtained in a 34-inch tube, a 29-inch tube, a 25-inch tube and a 14-inch tube, respectively. Points (a), (b), (c) and (d) show the creep rates of conventional grid apparatus without any metallic member 9 in the cathode ray tubes, respectively.

As is apparent from FIG. 3, in the grid apparatus 10 where the metallic members 9 which have a larger thermal expansion coefficient are connected to the reverse surfaces 11 of the resilient support members 3, 4 opposite to the grid-elements holding side, the thermal creep rate can be substantially reduced as compared with the rate in the conventional grid apparatus without any metallic member 9.

Consequently, when the grid apparatus 10 is placed in a normal temperature state again after the blackening process, high tension in the grid elements 6 will be maintained.

In the grid apparatus 10 of this embodiment, the phenomenon of thermal creep will be alleviated also during the frit sealing process for attaching a panel and a funnel during heat treatment.

Therefore, after completion of a television receiver with the cathode ray tube incorporated therein, the grid elements 6 will not be vibrated by any ordinary television sound level and consequently a high-quality video output can be ensured with minimized image noise.

In the embodiment described, the metallic members 9 which have a larger thermal expansion coefficient than that of the resilient support members 3, 4 of the frame 5 are securely attached, and when a blackening process is carried out under conditions where the tension which is applied to the grid elements 6 will be reduced by utilizing the difference between the thermal expansion coefficients of the resilient support members 3, 4 and the metallic members 9. However, reduction of the thermal creep rate can also be attained by another method which applies pressure to the pair of support bars 1, 2 of the frame 5 by mechanical means without joining the metallic members 9 and executes a blackening process under conditions where the tension of the grid elements 6 is substantially reduced.

Thus, due to execution of the blackening process under conditions where the tension applied to the grid elements 6 is reduced by utilizing the difference between the thermal expansion coefficients of the resilient support members ;3, 4 and the metallic members 9 or by mechanically bonding the frame 5, the thermal creep of the grid elements 6 can be suppressed to assure the manufacture of a satisfactory grid apparatus 10 in which high tension of the grid elements 6 is maintained.

According to the grid apparatus of the present invention, metallic members having a greater thermal expansion coefficient than a pair of resilient support members of a frame are attached to the reverse surfaces of the resilient support members on the side opposite to where the grid elements are attached, so that the thermal creep of the grid elements can be reduced during a blackening process and a subsequent frit sealing process for a panel and a funnel during heat treatment, thereby maintaining the tension of the grid elements sufficiently high after the heat treatment. consequently, when the present invention is applied to a television receiver, the grid elements will not be vibrated by ordinary television sound which will ensure a high-quality video output without image noise.

Furthermore, in the method of the present invention for making such grid apparatus heat treatment which includes a blackening process is carried out after the reduction of the tension applied to grid elements accomplished by a pair of resilient support members and a pair of support bars, whereby the thermal creep of the grid elements is suppressed during heat treatment. As a result, it becomes possible to manufacture a high-reliability grid apparatus where high tension of the grid elements is maintained.

Although the invention has been described with respect to preferred embodiments, it is not to be so limited as changes and modifications can be made which are within the full intended scope of the invention as defined by the appended claims.

## Claims

1. A grid apparatus for a color cathode ray tube comprising:
a frame (5) comprising a pair of mutually opposed support bars (1, 2) and a pair of resilient support members (3, 4) attached between said support bars (1, 2); and
a plurality of parallel ribbon-shaped grid elements (6) stretched under tension and attached to said frame (5);
**characterized by** metallic members (9) which have a larger thermal expansion coefficient than said resilient support members (3, 4) connected to reverse surfaces (11) of said resilient support members (3, 4) on the sides which are opposite to the grid elements (6).

2. A grid apparatus according to claim 1, wherein the thermal expansion coefficient of said resilient support members (3, 4) is in a range from 10 x 10⁻⁶ K⁻¹ to 12 x 10⁻⁶ K⁻¹.

3. A grid apparatus according to claim 1, wherein the thermal expansion coefficient of said metallic members (9) is in a range from 15 x 10⁻⁶ K⁻¹ to 50 x 10⁻⁶ K⁻¹.

4. A method of making a grid apparatus for a color cathode ray tube in which a plurality of ribbon-shaped grid elements (6) are stretched under tension and attached to a frame (5) consisting of a pair of mutually opposed support bars (1, 2) and a pair of resilient support members (3, 4) which are attached between said support bars (1, 2), said method including the following steps:
stretching the grid elements (6) with a predetermined tension on the frame (5);
attaching metallic members (9) to respective surfaces (11) of the two resilient support members (3, 4) on the sides which are opposite to the grid elements (6), said metallic members (9) having a larger coefficient of thermal expansion than said resilient support members (3, 4); and
carrying out heat treatment whereby the tension which is applied to said grid elements (6) by said resilient support members (3, 4) and said support bars (1, 2) is reduced.

5. A method according to claim 4, wherein said heat treatment includes a blackening process executed in a temperature range of 450 to 470°C.

## Patentansprüche

1. Gitter für eine Farbbildkathodenstrahlröhre, mit:
einem Rahmen (5) mit einem Paar von einander gegenüberstehenden Tragstäben (1, 2) und einem Paar von zwischen den Tragstäben (1, 2) befestigten elastischen Tragelementen (3, 4); und mit
einer Mehrzahl von parallelen, bandförmigen Gitterelementen (6). die unter Spannung gedehnt und an dem Rahmen (5) befestigt sind;
**gekennzeichnet durch** an rückwärtigen Oberflächen (11) der elastischen Tragelemente (3, 4) auf den Gitterelementen (6) gegenüberliegenden Seiten befestigte Metallelemente (9) mit einem größeren thermischen Ausdehnungskoeffizienten als dem der elastischen Tragelemente (3, 4).

2. Gitter nach Anspruch 1, **dadurch gekennzeichnet,** daß der thermische Ausdehnungskoeffizient der elastischen Tragelemente (3, 4) in einem Bereich von 10 x 10⁻⁶ K⁻¹ bis 12 x 10⁻⁶ K⁻¹ liegt.

3. Gitter nach Anspruch 1, **dadurch gekennzeichnet,** daß der thermische Ausdehnungskoeffizient der Metallelemente (9) in einem Bereich von 15 x 10⁻⁶ K⁻¹ bis 50 x 10⁻⁶ K⁻¹ liegt.

4. Verfahren zur Herstellung eines Gitters für eine Farbbildkathodenstrahlröhre, bei dem eine Mehrzahl von bandförmigen Gitterelementen (6) unter Spannung gedehnt und an einem Rahmen (5) befestigt ist, der aus einem Paar von einander gegenüberstehenden Tragstäben (1, 2) und einem Paar von zwischen den Tragstäben (1, 2) befestigten elastischen Tragelementen (3, 4) besteht, mit den Schritten:
Dehnen der Gitterelemente (6) mit einer bestimmten Spannung auf dem Rahmen (5);
Befestigen von Metallelementen (9) an jeweiligen Oberflächen (11) der zwei elastischen Tragelemente (3, 4) auf Seiten, die den Gitterelementen (6) gegenüberstehen, wobei die Metallelemente (9) einen größeren thermischen Ausdehnungskoeffizienten aufweisen als die elastischen Tragelemente (3, 4); und
Durchführen einer Wärmebehandlung, bei der die die Gitterelemente (6) durch die elastischen Tragelemente (3, 4) und die Tragstäbe (1, 2) beaufschlagende Spannung vermindert wird.

5. Verfahren nach Anspruch 4, **dadurch gekennzeichnet**, daß die Wärmebehandlung einen in einem Temperaturbereich von 450 bis 470 °C durchgeführten Schwärzungsprozeß einschließt.

## Revendications

1. Appareil à grille destiné à un tube à rayons cathodiques en couleurs, comprenant :
un cadre (5) qui comporte une paire de barres opposées de support (1, 2) et une paire d'organes élastiques de support (3, 4) fixés entre les barres de support (1, 2), et
plusieurs éléments (6) de grille en forme de ruban et parallèles, tendus sous tension et fixés au châssis (5),
caractérisé par des organes métalliques (9) dont le coefficient de dilatation thermique est supérieur à celui des organes élastiques de support (3, 4) et qui sont raccordés aux faces opposées (11) des organes élastiques de support (3, 4) sur les côtés opposés à celui des éléments de grille (6).

2. Appareil à grille selon la revendication 1, dans lequel le coefficient de dilatation thermique des organes élastiques de support (3, 4) est compris entre 10.10⁻⁶ et 12.10⁻⁶ K⁻¹.

3. Appareil à grille selon la revendication 1, dans lequel le coefficient de dilatation thermique des organes métalliques (9) est compris entre 15.10⁻⁶ et 50.10⁻⁶ K⁻¹.

4. Procédé de fabrication d'un appareil à grille pour tube à rayons cathodiques en couleurs, dans lequel plusieurs éléments de grille (6) en forme de ruban sont tendus sous tension et fixés à un cadre (5) formé de deux barres opposées de support (1, 2) et deux organes élastiques de support (3, 4) qui sont fixés entre les barres de support (1, 2), le procédé comprenant les étapes suivantes :
la mise sous tension d'éléments de grille (6) avec une tension prédéterminée sur le cadre (5),
la fixation d'organes métalliques (9) aux surfaces respectives (11) des deux organes élastiques de support (3, 4) sur les côtés opposés à celui des éléments de grille (6), les organes métalliques (9) ayant un coefficient de dilatation thermique supérieur à celui des organes élastiques de support (3, 4), et
l'exécution d'un traitement thermique de manière que la tension appliquée aux éléments de grille (6) par les organes élastiques de support (3, 4) et les barres de support (1, 2) soit réduite.

5. Procédé selon la revendication 4, dans lequel le traitement thermique comprend une opération de noircissement exécutée dans une plage de températures comprise entre 450 et 470 °C.
